# EUROPEAN PATENT APPLICATION

(11) **EP 1 061 567 A1**
(43) Date of publication of application: **20.12.2000**
(21) Application number: 00107496.2
(22) Date of filing: 06.04.2000
(51) Int. Cl.: H01L 21/316, H01L 21/3105

(54) **Method and apparatus for manufacturing an improved phosphosilicate glass film**

(30) Priority: 17.06.1999 JP 17155199
(71) Applicant: MITSUBISHI DENKI KABUSHIKI KAISHA, Tokyo 100-8310 (JP)
(72) Inventor: Fuji, Atsuhiro, c/o Mitsubishi Denki K. K., Tokyo 100-8310 (JP)
(74) Representative: Prüfer, Lutz H., Dipl.-Phys.

(57) **Abstract**

In a method of manufacturing a semiconductor device, a phosphosilicate glass insulating film mainly including trivalent phosphorus and containing phosphorous anhydride is formed on a substrate by feeding tetraethyl orthosilicate and either of trimethyl phosphite or trivalent phosphorus under a controlled reaction pressure in a vacuum chamber within a predetermined pressure range in an oxygen-free atmosphere, and by keeping a substrate temperature within a predetermined range. The phosphosilicate glass insulating film may further be annealed to to outwardly diffuse an excess of the phosphorous anhydride in the phosphosilicate glass insulating film and to flatten the surface of the interlayer insulating film. The phosphosilicate glass insulating film may further be oxidized with an oxidizing gas in order to convert the phosphorous anhydride left in the phosphosilicate glass insulating film into phosphoric anhydride.

## Description

### Background of the Invention

### Field of the Invention

This invention relates to a technique of forming an interlayer insulating film. More particularly, the invention relates to a method for forming a semiconductor device wherein an interlayer insulating film, which is free of a seam or cavity and has good planarization characteristics, can be formed as a thin film at low reflow temperatures, and also to an apparatus for manufacturing a semiconductor device having such an interlayer insulating film.

### Background Art

In a method of forming a planar insulating film, a borophosphosilcate glass film (boron/phosphorus-doped silica glass film or BPSG film) is formed by atmospheric pressure chemical vapor deposition (CVD), followed by thermal treatment (reflow) to planarize or flatten the film. Thereafter, the film is thinned and flattened by etching back or chemical mechanica polishing (CMP). Such a prior technique (first prior technique) is described, for example, in Japanese Patent No. 21600624, Japanese Patent Publication No. Hei 8-28363, Japanese Patent No. 2641956, Japanese Patent No. 2846671, Japanese Patent No. 2626925, and the like. In addition, there is a report described in 1986 V-MIC conf. P298, "Low Pressure CVD-HIGH QUALITY SiO₂ DIELECTRIC FILMS AT HIGH DEPOSITION RATES, Jams C. Mitchener, Focus Semiconductor Systems"

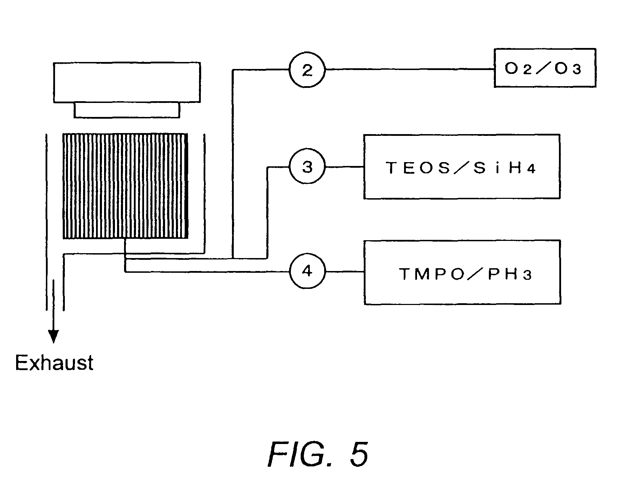

Fig. 5 shows a typical arrangement of a prior art film-forming apparatus. Referring to Fig. 5, the first prior art film-forming apparatus is called an SiH₄ system in which silane (SiH₄), phosphine (PH₃) and diborane (B₂H₆) are used as material gases. These material gases and oxygen gas (O₂) are reacted at 300 to 400°C at an atmospheric pressure to form a BPSG film. In the report set out in the above 1985 V-MIC, it is stated that low pressure CVD is used to form a BPSG film. However, the film is formed by oxidation in an atmosphere of oxygen, so that such a chemical reaction as indicted below in reaction formula 2 proceeds to form a BPSG film mixed with SiO₂. phosphoric anhydride (P₂O₅) (part of which consists of phosphorus anhydride (P₂O₃)) and B₂O₃.

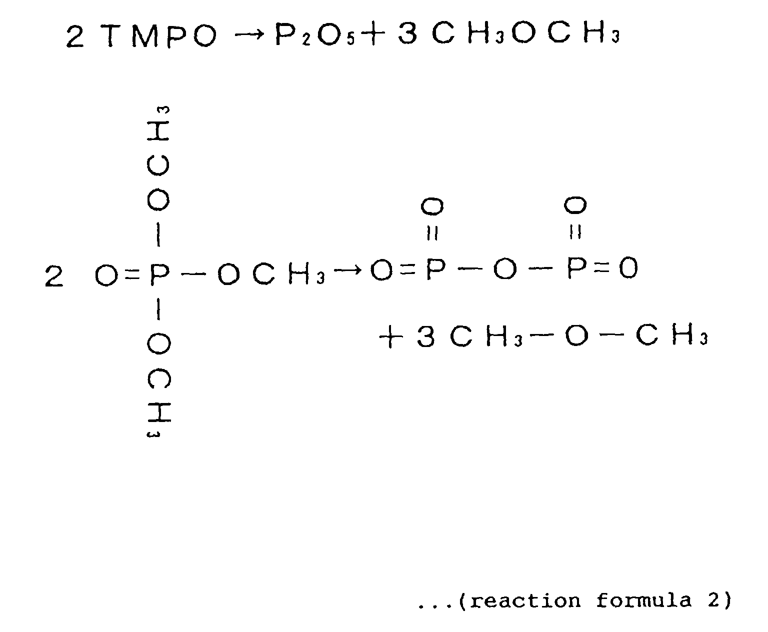

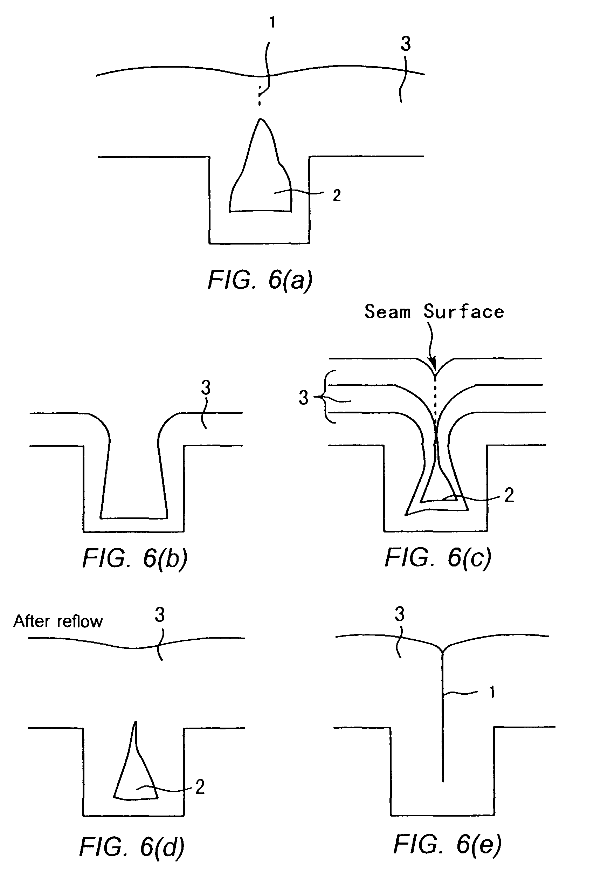

However, the first prior art technique of the SiH₄ system is poor in step coverage, thus presenting the problem that a seam 1 or a cavity 2 as shown in Fig. 6(a) is created in the BPSG film 3. A process of forming such a seam 1 or cavity 2 in the BPSG film 3 is shown in Figs. 6(b) to 6(e). In order to solve the above problem, there has been recently used atmospheric pressure CVD which makes use of organic materials and ensures good step coverage. In this case, tetraethyl orthosilicate (TEOS) is used as a material for SiO₂, trimethyl phosphate (TMPO) is used as a material for phosphoric anhydride (P₂O₅), and triethyl borate (TEB) or trimethyl borate (TMB) is used as a material for B₂O₃. These materials are oxidized by means of an O₃/O₂ mixed gas to cause a chemical reaction shown below in reaction formula 3 to proceed, thereby forming a BPSG film.

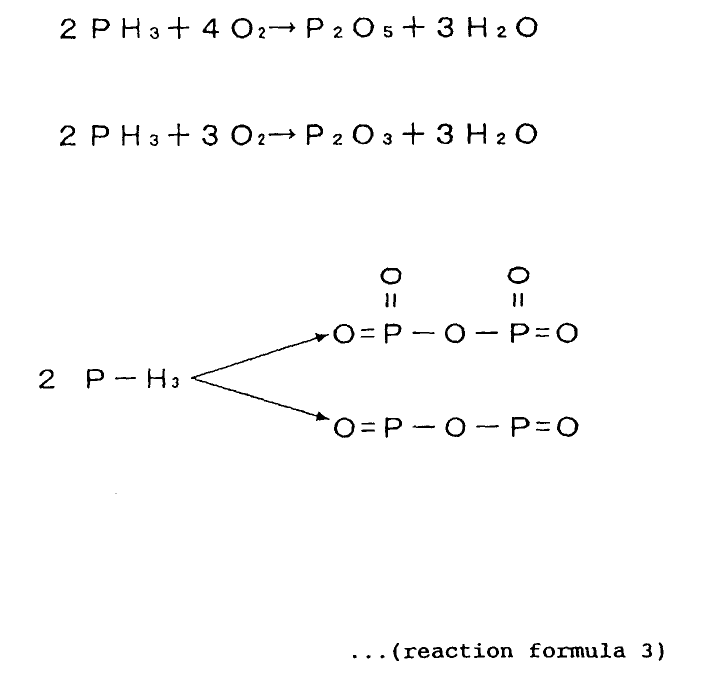

In order to make a fine device, it is essential that the reflow (thermal treatment) temperature of the BPSG film be rendered low. To lower the reflow (thermal treatment) temperature, impurities (phosphoric anhydride (P₂O₅) or B₂O₃) are added substantially to the limit. However, as the fineness of a device further proceeds, a temperature-lowering technique, which is attained by adding impurities (phosphoric anhydride (P₂O₅) or B₂O₃) substantially to the limit, has now reached substantially the limit. In recent years, it has been commenced to adopt planarization techniques using methods other than reflowing, such as chemical mechanical polishing (CMP), etching-back and the like. On the other hand, in the first prior art technique, a ratio of the material and an oxidizing agent is great sufficient to obtain a stable oxide. Especially, with respect to phosphorus (P), phosphoric anhydride (P₂O₅) has been prepared. Phosphorus has a plurality of oxidation numbers. Where phosphine (PH₃) is oxidized, phosphorous anhydride (P₂O₃) may be partially formed depending on conditions. Since phosphorous anhydride (P₂O₃) is very instable, an effort has been made in the first prior art technique wherein a film is formed in a fully oxygen-rich (especially, ozone (O₃) rich) atmosphere thereby obtaining stable phosphoric anhydride (P₂O₅). The use of organic materials (TMPO) enables one to improve step coverage as deposited and to make phosphoric anhydride (P₂O₅) reliably and stably. As is known in the art, phosphorous anhydride (P₂O₃) is instable when existing in BPSG after film formation, and undergoes sublimation (a change in concentration) and a change in film thickness (volumetric change) through absorption of water (or absorption of moisture) or a subsequent thermal treatment. To avoid this in the first prior art technique, the BPSG film has been formed under conditions which do not permit phosphorous anhydride (P₂O₃) to be formed in the BPSG film.

Other prior art techniques are described, for example, in Japanese Laid-open Patent Application No. Hei 6-333858 (second prior art technique). In the second prior art technique, it is stated in the paragraph [0021] of the publication that planarization proceeds by oxidizing phosphorus anhydride (P₂O₃) in BPSG into phosphoric anhydride (P₂O₅). It is disclosed that an increasing ratio of phosphorus anhydride (P₂O₃) enables one to realize low temperature planarization.

However, the above prior art technique has the following problems. A first problem resides in that a reflow (thermal treatment) temperature for flattening a BPSG film is so high that this technique is unlikely to be applied to fine devices such as 256 megabit class dynamic random access memory (DRAM). A second problem is that reflowing (thermal treatment) is unsatisfactory, so that step coverage degrades considerably, and thus, application to such fine devices as mentioned above becomes difficult owing to the existence of seams or cavities.

### Summary of the Invention

The present invention has been made in order to solve the problems set out above and has for its object the provision of a method for forming a semiconductor device and an apparatus for manufacturing a semiconductor device wherein an interlayer insulating film, which is free of a seam or cavity and has good planarization characteristics, is formed as a thin film at low reflow temperatures.

According to one aspect of the present invention, in a method of manufacturing a semiconductor device, formed on a substrate is a phosphosilicate glass insulating film mainly including trivalent phosphorus and containing phosphorous anhydride. The phosphosilicate glass insulating film is formed by feeding tetraethyl orthosilicate and, trimethyl phosphite or triethyl phosphate, and by controlling a reaction pressure in a vacuum chamber within a predetermined pressure range in an oxygen-free atmosphere. Further, a substrate temperature, is kept within a predetermined range.

In another aspect, in the method, the phosphosilicate glass insulating film may be further oxidized with an oxidizing gas in order to convert the phosphorous anhydride left in the phosphosilicate glass insulating film into phosphoric anhydride.

In another aspect, in the method, the interlayer insulating film may be annealed prior to the oxidation in order to outwardly diffuse an excess of the phosphorous anhydride in the phosphosilicate glass insulating film and to flatten the surface of the interlayer insulating film.

In another aspect of the present invention, a system for manufacturing a semiconductor device comprises a chamber for accommodating a substrate; an apparatus for introducing a vapor of tetraethyl orthosilicate under a controlled condition into the chamber; an apparatus for introducing a vapor of trimethyl phosphite or triethyl phosphate under a controlled condition into the chamber; an apparatus for introducing an oxidizing gas under a controlled condition into the chamber; an apparatus for introducing an inert gas under a controlled condition into the chamber; an apparatus for evacuating and controlling a pressure in the chamber; and an apparatus for controlling a temperature of the substrate in the chamber, whereby to form a phosphosilicate glass insulating film on the substrate by chemical vapor phase growth.

Other and further objects, features and advantages of the invention will appear more fully from the following description.

### Brief Description of the Drawings

Fig. 1 is a schematic view illustrating an apparatus for manufacturing a semiconductor device using a low pressure CVD method according to a first embodiment of the present invention.
Fig. 2 shows a flow chart of film formation illustrating a method of forming a semiconductor device using a low pressure CVD method according to the first embodiment of the present invention.
Fig. 3 is a sectional view of a semiconductor device for illustrating planarization at the time of film formation.
Fig. 4 is a schematic view illustrating another apparatus for manufacturing a semiconductor device using an atmospheric pressure CVD method according to the second embodiment of the present invention.
Fig. 5 shows a typical arrangement of a prior art film-forming apparatus.
Fig. 6 shows a typical method of manufacturing a semiconductor device in the prior art.

### Detailed Description of the Preferred Embodiments

Features of the embodiments described hereinbelow is to realize low temperature reflow by forming PSG (phosphosilicate glass) or BPSG (boro-phosphosilicate glass) by use of a trivalent phosphorus-doped silicate glass alone, i.e. phosphorous anhydride (P₂O₃), which has never been hitherto used due to its instability. To attain this feature, trimethyl phosphite (TMP), which is a trivalent phosphorus material, is subjected to decomposition (TMP decomposition) in an oxygen-free atmosphere to control the formation of phosphorus anhydride (P₂O₃). In this way, formation of a seam or cavity is prevented to improve planarization characteristics, and at the same time, the reflow temperature can be lowered. Embodiments of the invention are described below with reference to the accompanying drawings.

### First Embodiment

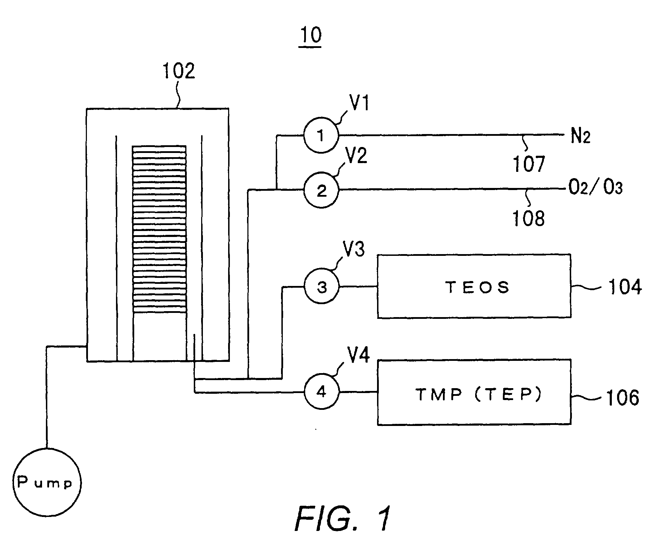

A first embodiment of the invention is described in detail with reference to the accompanying drawings. Fig. 1 is a schematic view illustrating an apparatus 10 for manufacturing a semiconductor device using a low pressure CVD method according to the first embodiment of the present invention. In Fig. 1, indicated by 102 is a vacuum chamber (low pressure CVD apparatus), by 104 is a vaporizer for tetraethyl orthosilicate (TEOS), by 106 is a vaporizer for trimethyl phosphite (TMP) or triethyl phosphite (TEP), by 107 is a feed line for an inert gas (nitrogen (N₂) gas), by 108 is a feed line for an oxidizing gas (oxygen (O₂) gas/ozone (O₃) gas), by Pᵤₘₚ is a vacuum pump, by V1 is a gas feed valve for an inert gas (nitrogen (N₂) gas), by V2 is a gas feed line for an oxidizing gas (oxygen (O₂) gas/ozone (O₃) gas), by V3 is a gas feed line for TEOS, and by V4 is a gas feed lien for TMP (TEP).

In this embodiment, phosphosilicate glass (PSG glass) or boro-phosphosilicate glass (BPSG galss) is formed as a film in the vacuum chamber (low pressure CVD apparatus) 102 under oxygen-free conditions, for which such a chemical reaction as shown below in reaction formula 1 proceeds. In the reaction, phosphorous anhydride (P₂O₃) is stably formed, and a phosphosilicate glass interlayer insulating film (P₃SG film), which is mainly composed of trivalent phosphorus without conversion (oxidation) into phosphoric anhydride (P₂O₅), is formed. As a consequence, PSG or BPSG, which is free of a seam or cavity and has good planarization characteristics, can be formed as a thin film at low reflow temperatures.

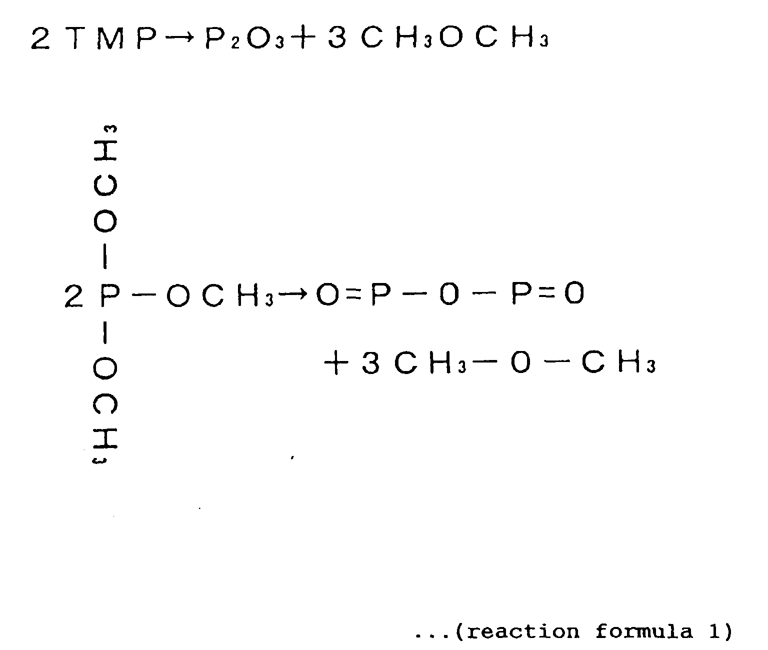

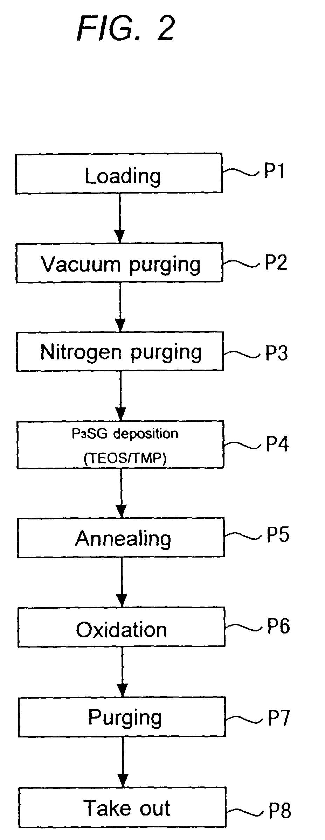

Fig. 2 shows a flow chart of film formation illustrating a method of forming a semiconductor device using a low pressure CVD method according to the first embodiment of the present invention. A sequence of manufacturing processes (processes P1 to P8) shown in Fig. 2 should be performed continuously without exposure to air. Referring to Fig. 2, in this embodiment of the invention, a wafer is initially inserted (loading: process P1) into the vacuum chamber (low pressure CVD apparatus) 102 wherein the vacuum chamber (low pressure CVD apparatus) 102 is subjected to vacuum purging (process P2) in order to remove oxygen in air.

Next, the vacuum chamber (low pressure CVD apparatus) 102 is further subjected to nitrogen purging (process P3), followed by further expelling of oxygen while keeping the wafer at a given temperature.

Thereafter, film-forming processes (processes P4 to P8) are carried out. One instance of the film-forming processes (processes P4 to P8) is as follows. While feeding tetraethyl orthosilicate (TEOS) from the vaporizer 104 for TEOS at a rate of about 1 g/minute under control of the gas feed valve V3 for TEOS or trimethyl phosphite (TMP) is fed from the vaporizer 106 for TMP (TEP) at a rate of about 0.2 to 0.25 g/minute under control of the gas feed valve V4 for TMP (TEP). The reaction pressure within the vacuum chamber (low pressure CVD apparatus) 102 is controlled at about 100 to 500 Pa while controlling a total stroke volume by means of the vacuum pump Pᵤₘₚ. Under these conditions, while the substrate temperature is maintained at about 600 to 700°C, film formation (P₃SG deposition (TEOS/TMP): process P4) is performed so that a phosphosilicate glass interlayer insulating film (P₃SG film) made primarily of trivalent phosphorus is formed. Where it is necessary to increase the reaction pressure within the vacuum chamber (low pressure CVD apparatus) 102, the stroke volume of the vacuum pump Pᵤₘₚ is reduced, and the gas feed valve V1 for an inert gas (nitrogen (N₂) gas) is opened to supply the inert gas (nitrogen (N₂) gas) from the inert gas (nitrogen (N₂) gas) feed line 107 to the vacuum chamber (low pressure CVD apparatus) 102, thereby increasing the pressure.

Thereafter, annealing treatment (annealing: process P5) is performed so that an excess of phosphorous anhydride (P₂O₃) taken in the phosphosilicate glass interlayer insulating film (P₃SG film) (wherein the concentration of phosphorous anhydride (P₂O₃) is considered to be at about 15 mole%) is expelled from the film (in other words, an excess of phosphorous anhydride (P₂O₃) in the phosphosilicate glass interlayer insulating film (P₃SG film) mainly composed of trivalent phosphorus is externally diffused (or sublimated), and good flatness is ensured.

In order to convert phosphorous anhydride (P₂O₃), which is left in the phosphosilicate glass interlayer insulating film mainly composed of trivalent phosphorus (P₃SG film), into phosphoric anhydride (P₂O₅), the gas feed valve V2 for an oxidative gas (oxygen (O₂) gas/ozone (O₃) gas) is controlled (or opened) to supply an oxidative gas such as oxygen (O₂) gas or ozone (O₃) gas from the feed line 108, thereby carrying out oxidation treatment (oxidation: process P6). P₅SG (phosphosilicate glass made of pentavalent phosphoric) formed after the oxidation treatment (oxidation: process P6) is the same as hitherto employed PSG, and is stable and ensures good matching with known manufacturing processes.

In this embodiment, an annealing treatment (annealing: process P5) for outwardly diffusing (sublimating) an excess of phosphorous anhydride (P₂O₃) present in the phosphosilicate glass interlayer insulating film (P₃SG film) mainly composed of trivalent phosphorus is carried out in an oxygen-free atmosphere continuously with the film formation at temperatures lower than a conventional reflow (thermal treatment) temperature. Moreover, in order to oxidize the phosphosilicate glass (P₃SG) left in the phosphosilicate glass interlayer insulating film (P₃SG film) mainly composed of trivalent phosphorus, the oxidation treatment (oxidation: process P6) is effected in an atmosphere of oxygen (a mixture with ozone may be used). Although the phosphorus concentration is at a high level (higher than a solid solution limit) at the time of growth of the phosphosilicate glass interlayer insulating film (P₃SG film), the glass undergoes the outward diffusion (sublimation), so that the phosphorus concentration in a final P₅SG film is about at 8 mole%.

Next, a residual gas in the vacuum chamber (low pressure CVD apparatus) 102 is purged (purging: process P7), followed by returning the vacuum chamber (low pressure CVD apparatus) 102 to an atmospheric pressure. Then, the wafer is taken out (take out: process P8). Through the above processes, the phosphosilicate glass interlayer insulating film ((P₃SG film) is formed to provide a thin film of PSG or BPSG.

The vaporizer 104 for tetraethyl orthosilicate (TEOS) or the vaporizer 106 for TMP/TEP may be either of the bubbler type using an inert gas or of the direct vaporizing type (differential operation using a difference in vapor pressure). In view of the control under relatively high pressures, it is preferred to use a direct vaporizing type.

Phosphosilicate glass (P₃SG), which constitutes the phosphosilicate glass interlayer insulating film (P₃SG film) mainly composed of trivalent phosphorus, becomes low in glass transition temperature Tg than conventionally employed boro-phosphosilicate glass (BPSG glass). Accordingly, B₂O₃ is not necessary in this embodiment. It will be noted that where it is needed to further lower the process temperature for the film formation, B₂O₃ may be added, as required.

In the above embodiment, it is illustrated to use trimethyl phosphite (TMP) as a phosphorus material, but the phosphorus material is not limited to one mentioned above. When using triethyl phosphite (TEP), there can be formed a thin film of PSG or BPSG at a low reflow temperature, which does not contain any seam or cavity and exhibits good planarization characteristics.

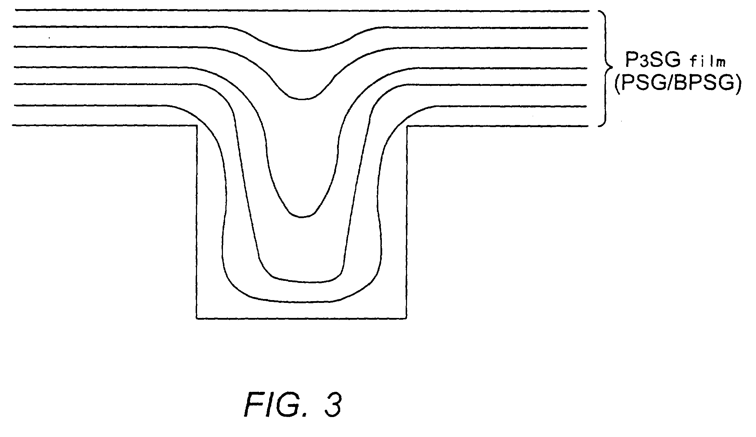

Fig. 3 is a sectional view of a device for illustrating planarization at the time of film formation. Since the film-forming temperature is higher than a glass transition temperature Tg of the phosphosilicate glass interlayer insulating film (P₃SG film) mainly made of trivalent phosphorus, the thermal treatment (reflow) is carried out simultaneously with film formation, thereby obtaining a flattened or planarized phosphosilicate glass interlayer insulating film (P₃SG film) as shown in Fig. 3. More particularly, while forming the phosphosilicate glass interlayer insulating film (P₃SG film) mainly made of trivalent phosphorus, the planarization is performed without formation of a seam 1 or a cavity 2 as shown in Fig. 6, thereby obtaining the phosphosilicate glass interlayer insulating film (P₃SG film) as a good interlayer insulating film. Thus, PSG or BPSG, which is free of a seam or cavity and exhibits good planarization characteristics, can be formed as a thin film at low reflow temperatures.

### Second Embodiment

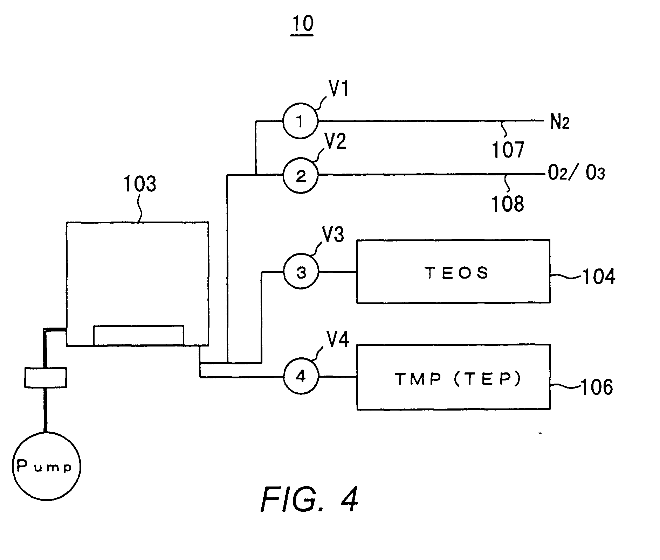

A second embodiment of the present invention is described in detail with reference to the drawings. It will be noted that like members or parts illustrated in the first embodiment are indicated by like reference numerals and are not further explained again for convenience's sake. Fig. 4 is a schematic view illustrating an apparatus 10 for manufacturing a semiconductor device using an atmospheric pressure CVD method according to the second embodiment of the present invention. In Fig. 4, indicated by 103 is a vacuum chamber (atmospheric pressure CVD apparatus), by 104 is a vaporizer for tetraethyl orthosilicate (TEOS), by 106 is a vaporizer for trimethyl phosphite (TMP) or triethyl phosphite (TEP), by 107 is an inert gas (nitrogen (N₂) gas) feed line, by 108 is an oxidative gas (oxygen (O₂) gas/ozone (O₃) gas) feed line, by Pᵤₘₚ is a vacuum pump, by V1 is a gas feed valve for an inert gas (nitrogen (N₂) gas), by V2 is a gas feed valve for an oxidative gas (oxygen (O₂) gas/ozone (O₃) gas), by V3 is a gas feed valve for TEOS, and by V4 is a gas feed valve for TMP (TEP). Referring to Fig. 4, the apparatus 10 of this embodiment should preferably be of a single wafer processing type because of the difficulty in full purge usually by mixing with oxygen when a film-forming zone is fully purged with an inert gas (nitrogen (N₂) gas) to make an oxygen-free conditions. The vaporizer 104 for tetraethyl orthosilicate (TEOS) and the vaporizer 106 for TMP/TEP may be of any type wherein no oxygen is incorporated including a bubbler type using nitrogen (N₂) gas, or a type forced with nitrogen after direct vaporization.

The second embodiment is characterized in that although processes P1 to P3 of the sequence of manufacturing processes (processes P1 to P8) shown in Fig. 2 are conducted in the same manner as in the first embodiment, the reaction temperature is set at a level higher than those used in ordinary atmospheric CVD and the film formation step should proceed in a closed state. More particularly, since the temperature, at which the phosphosilicate glass interlayer insulating film (P₃SG film) mainly made of trivalent phosphorus is formed, is higher than a glass softening temperature, the thermal treatment (reflow) is performed immediately after the film formation. Thereafter, phosphorous anhydride (P₂O₃), which is added in excess over the solid solution limit, is diffused outwardly (sublimated) and a thermal treatment (reflow) necessary for the control of flatness is carried out. The concentration of phosphorus at the time of film growth is high (i.e. over a solid solution limit), and the concentration of phosphorus in a P₅SG film finally obtained after the outward diffusion (sublimation) is about at 8 mole%. Finally, oxidation treatment with an oxidative gas (oxygen (O₂) gas/ozone (O₃) gas) is performed for conversion into phosphoric anhydride (P₂O₅) to permit it to be released in air, thereby finally forming P₅SG (phosphosilicate glass made of pentavalent phosphoric). Eventually, PSG or BPSG, which is free of a seam or cavity and exhibits good planarization characteristics, can be formed as a thin film at low reflow temperatures. The thus formed P₅SG (phosphosilicate glass made of pentavalent phosphoric) is the same as conventionally employed PSG, and is stable and ensures good matching with a prior art manufacturing process.

The above embodiment is illustrated, which makes use of trimethyl phosphite (TMP) as a phosphorus material, but is not limited to such a material. When using triethyl phosphite (TEP), PSG or BPSG, which is free of a seam or cavity and exhibits good planarization characteristics, can be likewise formed as a thin film at low reflow temperatures. In this embodiment, trimethyl phosphite (TMP) and tetraethyl orthosilicate (TEOS) are, respectively, vaporized in separate vaporizers, i.e. the vaporizer 106 for trimethyl phosphite (TMP) or triethyl phosphite (TEP) and the vaporizer 104 for tetraethyl orthosilicate (TEOS), and fed to the vacuum chamber (low pressure CVD apparatus). However, this mode of vaporization is not critical, and a mixture of trimethyl phosphite (TMP) and tetraethyl orthosilicate (TEOS) mixed in one tank may be gasified in one vaporizer and fed to the vacuum chamber (low pressure CVD apparatus). In this arrangement, expensive vaporizers can be reduced in number, thereby enabling one to reduce the cost of the apparatus and simplify the total system.

As will be apparent from the foregoing, the respective embodiments of the invention have the following effects or features. A first feature resides in that there can be obtained a phosphosilicate glass interlayer insulating film (P₃SG film) which is free of a seam or cavity and exhibits good planarization characteristics and is mainly composed of trivalent phosphorus. A second feature resides in that there can be obtained a phosphosilicate glass interlayer insulating film (P₃SG film) which is mainly made of trivalent phosphorus and contains phosphoric anhydride (P₂O₅) and whose phosphorus is kept at a given concentration irrespective of film growth conditions. A third feature resides in that the formation of a seam or cavity can be prevented along with improved planarization characteristics and, at the same time, a low reflow temperature can be realized by use of a simple arrangement wherein there are added, to a known low pressure CVD apparatus, only a vaporizer 106 for a trimethyl phosphite (TMP) source (TMP (TEP)) and a feed line 108 for an oxidative gas (oxygen (O₂) gas/ozone (O₃) gas).

The invention should not be construed as limiting to those embodiments described herein above, and many variations and alterations of the embodiments within the scope of the invention can be apparently made. The above embodiments are not limited to those set out above with respect to the number, positions and shapes of individual members or parts, which may be conveniently changed for carrying out the invention. In the figures, like reference numerals indicate like parts or members, respectively.

As described hereinbefore, the present invention or each of the embodiments has the following features, advantages and effects, which are summarized below.

In one aspect, the invention is directed to a method for forming a semiconductor wherein an interlayer insulating film, which is substantially free of a seam or cavity and has good planarization characteristics, can be formed as a thin film at a low reflow temperature. The method comprises the steps of forming, on a substrate, a phosphosilicate glass interlayer insulating film containing phosphorous anhydride and mainly composed of trivalent phosphorus by feeding tetraethyl orthosilicate and trimethyl phosphite (TMP) used as a trivalent phosphorus material to a substrate, controlling a reaction pressure in a vacuum chamber within a predetermined pressure range and decomposing the trimethyl phosphite (TMP) used as a trivalent phosphorus material in an oxygen-free atmosphere while keeping a substrate temperature within a predetermined range, and converting the phosphorous anhydride contained in the phosphosilicate glass interlayer insulating film into phosphoric anhydride. This method has the following features. A first feature resides in that there can be obtained a phosphosilicate glass interlayer insulating film mainly composed of trivalent phosphorus, which is free of a seam or cavity and has good planarization characteristics, by use of tetraethyl orthosilicate and trimethyl phosphite (TMP) as main starting materials. A second feature is that there can be obtained a phosphosilicate glass interlayer insulating film which makes use of tetraethyl orthosilicate and trimethyl phosphite (TMP) as main starting materials, has phosphorus kept at a given concentration irrespective of film growth conditions, and is mainly composed of trivalent phosphorus along with phosphoric anhydride. A third feature resides in that the formation of a seam or cavity can be prevented along with improved planarization characteristics and, at the same time, a low reflow temperature can be realized by use of a simple arrangement wherein a source for trimethyl phosphite (TMP) and a feed line for an oxidative gas are only added to a known low pressure CVD apparatus.

In another aspect, the method comprises the first step of forming the film, on the substrate, the phosphosilicate glass interlayer insulating film mainly composed of trivalent phosphorus by feeding tetraethyl orthosilicate and trimethyl phosphite (TMP) to the substrate, and controlling a reaction pressure in a vacuum chamber within a predetermined pressure range while keeping a substrate temperature within a predetermined range. As a result, the phosphosilicate glass interlayer insulating film, which is free of a seam or cavity, exhibits good planarization characteristics and is mainly composed of trivalent phosphorus, can be formed from tetraethyl orthosilicate and trimethyl phosphite (TMP).

In another aspect, the method for forming a semiconductor device according to the invention is able to form a thin interlayer insulating film, which is free of a seam or cavity and exhibits good planarization characteristics, at a low reflow temperature. The method comprises the steps of forming, on a substrate, a phosphosilicate glass interlayer insulating film containing phosphorous anhydride and mainly composed of trivalent phosphorus by feeding tetraethyl orthosilicate and triethyl phosphite (TEP) used as a trivalent phosphorus material to the substrate, controlling a reaction pressure in a vacuum chamber within a predetermined pressure range and decomposing the triethyl phosphite (TEP) used as a trivalent phosphorus material in an oxygen-free atmosphere while keeping a substrate temperature within a predetermined range, and converting the phosphorous anhydride contained in the phosphosilicate glass interlayer insulating film into phosphoric anhydride. This method has the following features. A first feature resides in that there can be obtained a phosphosilicate glass interlayer insulating film mainly composed of trivalent phosphorus, which is free of a seam or cavity and has good planarization characteristics, by use of tetraethyl orthosilicate and triethyl phosphite (TEP) as main starting materials. A second feature is that there can be obtained a phosphosilicate glass interlayer insulating film which makes use of tetraethyl orthosilicate and triethyl phosphite (TEP) as main starting materials, has phosphorus kept at a given concentration irrespective of film growth conditions, and is mainly composed of trivalent phosphorus along with phosphoric anhydride. A third feature resides in that the formation of a seam or cavity can be prevented along with improved planarization characteristics and, at the same time, a low reflow temperature can be realized by use of a simple arrangement wherein a source for triethyl phosphite (TEP) and a feed line for an oxidative gas are only added to a known low pressure CVD apparatus.

In another aspect, the method comprises the first step of forming the film, on the substrate, the phosphosilicate glass interlayer insulating film mainly composed of trivalent phosphorus by feeding tetraethyl orthosilicate and triethyl phosphite (TEP) to the substrate, and controlling a reaction pressure in a vacuum chamber within a predetermined pressure range while keeping a substrate temperature within a predetermined range. As a result, the phosphosilicate glass interlayer insulating film, which is free of a seam or cavity, exhibits good planarization characteristics and is mainly composed of trivalent phosphorus, can be formed from tetraethyl orthosilicate and triethyl phosphite (TEP).

In another aspect, the method further comprises the second step of expelling the phosphorous anhydride taken in the phosphosilicate glass interlayer insulating film in excess from the interlayer insulating film and subjecting the interlayer insulating film to annealing in order to obtain flatness, so that similar effects can be obtained.

In another aspect, the method further comprises the third step of feeding an oxidative gas for oxidation of the interlayer insulating film for conversion of phosphorous anhydride left in the phosphosilicate glass interlayer insulating film mainly composed of trivalent phosphorus into phosphoric anhydride, so that similar effects are attained.

In another aspect, the method further comprises the fourth step of subjecting the interlayer insulating film to oxidation treatment with an oxidative gas in order to convert the trivalent phosphorus-doped silicate glass component left in the phosphosilicate glass interlayer insulating film mainly composed of trivalent phosphorus into phosphoric anhydride, so that similar effects are obtained.

In another aspect, the method further comprises the fifth step of purging a gas left in the vacuum chamber, with the result that similar effects are obtained.

In another aspect, the second step of the method comprises the steps of outwardly diffusing phosphorous anhydride present, in excess, in the phosphosilicate glass interlayer insulating film mainly composed of trivalent phosphorus and annealing the interlayer insulating film so as to flatten or planarize the film. Eventually, similar effects are obtained.

In another aspect, a semiconductor manufacturing apparatus of the invention is able to form a thin interlayer insulating film, which is substantially free of a seam or cavity and exhibits good planarization characteristics, at a low reflow temperature. The apparatus comprises means for forming a phosphosilicate glass interlayer insulating film containing phosphorous anhydride and mainly composed of trivalent phosphorus on a substrate by chemical vapor phase growth by feeding, to a substrate, vapors of tetraethyl orthosilicate and trimethyl phosphite (TMP) serving as a trivalent phosphorus material, controlling a reaction pressure in a vacuum chamber within a predetermined pressure range, and decomposing the trimethyl phosphite (TMP) used as the trivalent phosphorus material in an oxygen-free atmosphere while keeping a substrate temperature within a predetermined temperature range, and means for converting phosphorous anhydride left in the phosphosilicate glass interlayer insulating film into phosphoric anhydride. The apparatus has the following features. A first feature resides in that there can be obtained a phosphosilicate glass interlayer insulating film mainly composed of trivalent phosphorus, which is free of a seam or cavity and has good planarization characteristics, by use of tetraethyl orthosilicate and trimethyl phosphite (TMP) as main starting materials. A second feature is that there can be obtained a phosphosilicate glass interlayer insulating film which makes use of tetraethyl orthosilicate and trimethyl phosphite (TMP) as main starting materials, has phosphorus kept at a given concentration irrespective of film growth conditions, and is mainly composed of trivalent phosphorus along with phosphoric anhydride. A third feature resides in that the formation of a seam or cavity can be prevented along with improved planarization characteristics and, at the same time, a low reflow temperature can be realized by use of a simple arrangement wherein a source for trimethyl phosphite (TMP) and a feed line for an oxidative gas are only added to a known low pressure CVD apparatus.

In another aspect, the semiconductor manufacturing apparatus comprises means for forming the phosphosilicate glass interlayer insulating film mainly composed of trivalent phosphorus on the substrate by chemical vapor phase growth by feeding, to the substrate, vapors of tetraethyl orthosilicate and trimethyl phosphite (TMP), controlling the reaction pressure in the vacuum chamber within a predetermined pressure range, and keeping a substrate temperature within a predetermined temperature range, so that there can be realized the formation of the phosphosilicate interlayer insulating film, which is free of a seam or cavity, exhibits good planarization characteristics and is mainly composed of trivalent phosphorus, from tetraethyl orthosilicate and trimethyl phosphite (TMP).

In another aspect, the semiconductor manufacturing apparatus is able to form a thin interlayer insulating film, which is free of a seam or cavity and exhibits good planarization characteristics, at a low reflow temperature. The apparatus comprises means for forming a phosphosilicate glass interlayer insulating film containing phosphorous anhydride and mainly composed of trivalent phosphorus on a substrate by chemical vapor phase growth by feeding, to a substrate, vapors of tetraethyl orthosilicate and triethyl phosphite (TEP) serving as a trivalent phosphorus material, controlling a reaction pressure in a vacuum chamber within a predetermined pressure range, and decomposing the triethyl phosphite (TEP) used as the trivalent phosphorus material in an oxygen-tree atmosphere while keeping a substrate temperature within a predetermined temperature range, and means for converting phosphorous anhydride contained in the phosphosilicate glass interlayer insulating film into phosphoric anhydride. The apparatus has the following features. A first feature resides in that there can be obtained a phosphosilicate glass interlayer insulating film mainly composed of trivalent phosphorus, which is free of a seam or cavity and has good planarization characteristics, by use of tetraethyl orthosilicate and triethyl phosphite (TEP) as main starting materials. A second feature is that there can be obtained a phosphosilicate glass interlayer insulating film which makes use of tetraethyl orthosilicate and triethyl phosphite (TEP) as main starting materials, has phosphorus kept at a given concentration irrespective of film growth conditions, and is mainly composed of trivalent phosphorus along with phosphoric anhydride. A third feature resides in that the formation of a seam or cavity can be prevented along with improved planarization characteristics and, at the same time, a low reflow temperature can be realized by use of a simple arrangement wherein a source for triethyl phosphite (TEP) and a feed line for an oxidative gas are only added to a known low pressure CVD apparatus.

In another aspect, the semiconductor manufacturing apparatus comprises means for forming the phosphosilicate glass interlayer insulating film mainly composed of trivalent phosphorus on the substrate by chemical vapor phase growth by feeding, to the substrate, vapors of tetraethyl orthosilicate and triethyl phosphite (TEP), controlling a reaction pressure in the vacuum chamber within a predetermined pressure range, and keeping a substrate temperature within a predetermined temperature range. Thus, there can be formed the phosphosilicate glass interlayer insulating film, which is free of a seam or cavity, has good planarization characteristics and is mainly composed of trivalent phosphorus, from tetraethyl orthosilicate and triethyl phosphite (TEP).

In another aspect, the semiconductor manufacturing apparatus further comprises means for expelling phosphoric anhydride taken in the phosphosilicate glass interlayer insulating film in excess during the course of the chemical vapor growth of the interlayer insulating film from the interlayer insulating film and also annealing the interlayer insulating film in order to ensure high flatness. Thus, similar effects are are obtained.

In another aspect, the semiconductor manufacturing apparatus further comprises means for oxidizing the insulating film with an oxidative gas in order to convert phosphorous anhydride left in the phosphosilicate glass interlayer insulating film mainly composed of trivalent phosphorus into phosphoric anhydride. Thus, similar effects are obtained.

In another aspect, the semiconductor manufacturing apparatus further comprises means for oxidation with an oxidative gas in order to oxidize a trivalent phosphorus-doped silicate glass component left in the phosphosilicate glass interlayer insulating film mainly composed of trivalent phosphorus for conversion into phosphoric anhydride. Thus, similar effects are obtained.

In another aspect, the semiconductor manufacturing apparatus further comprises means for purging a gas left in the vacuum chamber. Thus, similar effects are obtained.

In another aspect, the semiconductor manufacturing apparatus further comprises means for outwardly diffusing phosphorous anhydride present in excess taken in the phosphosilicate glass interlayer insulating film during the course of the chemical vapor phase growth of the phosphosilicate glass interlayer insulating film mainly composed of trivalent phosphorus and annealing the insulating film in order to obtain good flatness of the film. Thus, similar effects are obtained.

Obviously many modifications and variations of the present invention are possible in the light of the above teachings. It is therefore to be understood that within the scope of the appended claims the invention may by practiced otherwise than as specifically described.

The entire disclosure of a Japanese Patent Application No. 11-171551, filed on June 17, 1999 including specification, claims, drawings and summary, on which the Convention priority of the present application is based, are incorporated herein by reference in its entirety.

## Claims

1. A method of manufacturing a semiconductor device, comprising at least a step of:
forming, on a substrate, a phosphosilicate glass insulating film mainly including trivalent phosphorus and containing phosphorous anhydride, by feeding tetraethyl orthosilicate and trimethyl phosphite, by controlling a reaction pressure in a vacuum chamber within a predetermined pressure range in an oxygen-free atmosphere, and by keeping a substrate temperature within a predetermined range.

2. The method of manufacturing a semiconductor device according to claim 1, further comprising the step of:
oxidizing said phosphosilicate glass insulating film with an oxidizing gas in order to convert said phosphorous anhydride left in said phosphosilicate glass insulating film into phosphoric anhydride.

3. The method of manufacturing a semiconductor device according to claim 1, further comprising the subsequent step of :
annealing said interlayer insulating film in order to outwardly diffuse an excess of said phosphorous anhydride in said phosphosilicate glass insulating film and to flatten the surface of said interlayer insulating film.

4. The method of manufacturing a semiconductor device according to claim 3, further comprising the subsequent step of:
oxidizing said phosphosilicate glass insulating film with an oxidizing gas in order to convert said phosphorous anhydride left in said phosphosilicate glass insulating film into phosphoric anhydride.

5. A method of manufacturing a semiconductor device, comprising at least a step of:
forming, on a substrate, a phosphosilicate glass insulating film mainly including trivalent phosphorus and containing phosphorous anhydride, by feeding tetraethyl orthosilicate and triethyl phosphite, by controlling a reaction pressure in a vacuum chamber within a predetermined pressure range in an oxygen-free atmosphere, and by keeping a substrate temperature within a predetermined range.

6. The method of manufacturing a semiconductor device according to claim 1, further comprising the step of:
oxidizing said phosphosilicate glass insulating film with an oxidizing gas in order to convert said phosphorous anhydride left in said phosphosilicate glass insulating film into phosphoric anhydride.

7. The method of manufacturing a semiconductor device according to claim 1, further comprising the subsequent step of :
annealing said interlayer insulating film in order to outwardly diffuse an excess of said phosphorous anhydride in said phosphosilicate glass insulating film and to flatten the surface of said interlayer insulating film.

8. The method of manufacturing a semiconductor device according to claim 3, further comprising the subsequent step of:
oxidizing said phosphosilicate glass insulating film with an oxidizing gas in order to convert said phosphorous anhydride left in said phosphosilicate glass insulating film into phosphoric anhydride.

9. A system for manufacturing a semiconductor device comprising:
a chamber for accommodating a substrate;
an apparatus for introducing a vapor of tetraethyl orthosilicate under a controlled condition into said chamber;
an apparatus for introducing a vapor of trimethyl phosphite or triethyl phosphite under a controlled condition into said chamber;
an apparatus for introducing an oxidizing gas under a controlled condition into said chamber;
an apparatus for introducing an inert gas under a controlled condition into said chamber;
an apparatus for evacuating and controlling a pressure in said chamber; and
an apparatus for controlling a temperature of said substrate in said chamber, whereby to form a phosphosilicate glass insulating film on said substrate by chemical vapor phase growth.
